# DEMANDE DE BREVET EUROPEEN

(11) **EP 3 972 111 A1**
(43) Date de publication de la demande: **23.03.2022**
(21) Numéro de dépôt: 21197520.6
(22) Date de dépôt: 17.09.2021
(51) Int. Cl.: H02M 7/219, H02M 7/48, H02M 1/088, H03K 17/30, H02M 3/335, H02M 1/00

(54) **COMMANDE DE DEUX INTERRUPTEURS EN SÉRIE**

(30) Priorité: 18.09.2020 FR 2009484
(71) Demandeur: Commissariat à l'Energie Atomique et aux Energies Alternatives, 75015 Paris (FR)
(72) Inventeur: STERNA, Léo, 38054 GRENOBLE CEDEX 09 (FR); PERICHON, Pierre, 38054 GRENOBLE CEDEX 09 (FR)
(74) Mandataire: Cabinet Beaumont

(57) **Abrégé**

La présente description concerne un procédé et un circuit de commande de premier (210-1) et deuxième (210-2) interrupteurs électriquement en série, dans lequel un ou des franchissements d'un seuil de tension (VTH) par une tension aux bornes du premier interrupteur provoquent un état passant du deuxième interrupteur.

## Description

### Domaine technique

La présente description concerne de façon générale les dispositifs électroniques, en particulier les convertisseurs à découpage.

### Technique antérieure

Les convertisseurs à découpage utilisent un ou des interrupteurs mis alternativement aux états passant et bloqué à une fréquence de découpage. On utilise des convertisseurs à découpage pour fournir une tension et/ou un courant à partir d'une alimentation ayant des valeurs de tension/courant différentes des valeurs des tension/courant à fournir. Par exemple, un convertisseur à découpage de type alternatif-continu AC-DC (en anglais "Alternating Current-Direct Current") permet d'obtenir une tension continue à partir d'une tension alternative telle que celle d'un réseau électrique ou d'un alternateur.

### Résumé de l'invention

Il existe un besoin d'améliorer le fonctionnement des convertisseurs à découpage connus, en particulier des convertisseurs connus recevant et/ou fournissant une tension alternative.

Il existe un besoin de simplifier la mise en œuvre d'interrupteurs des convertisseurs à découpage connus, en particulier des convertisseurs connus recevant et/ou fournissant une tension alternative.

Il existe un besoin d'améliorer le rendement et/ou la fiabilité des convertisseurs à découpage connus.

Un mode de réalisation pallie tout ou partie des inconvénients des procédés connus de commande d'interrupteurs.

Un mode de réalisation pallie tout ou partie des inconvénients des convertisseurs connus.

Un mode de réalisation permet de simplifier la mise en œuvre d'interrupteurs de convertisseurs à découpage connus, en particulier des convertisseurs connus recevant et/ou fournissant une tension alternative.

Un mode de réalisation permet d'améliorer le rendement et/ou la fiabilité des convertisseurs à découpage connus, en particulier des convertisseurs connus recevant et/ou fournissant une tension alternative.

Un mode de réalisation prévoit un procédé de commande de premier et deuxième interrupteurs électriquement en série, lesdits interrupteurs étant des transistors à effet de champ dont des bornes de source sont interconnectées dans lequel :
un ou des franchissements d'un premier seuil de tension par une tension aux bornes du premier interrupteur provoquent un état passant du deuxième interrupteur ; et
un ou des franchissements d'un deuxième seuil de tension par une tension aux bornes du deuxième interrupteur provoquent un état passant du premier interrupteur.

Selon un mode de réalisation, des premières périodes d'application d'une commande en créneaux au premier interrupteur et d'état passant du deuxième interrupteur débutent par lesdits franchissements.

Selon un mode de réalisation, chaque créneau de la commande provoque un autre franchissement du seuil de tension par la tension aux bornes du premier interrupteur, et chaque première période se termine à un délai prédéfini après un dernier desdits autres franchissements situés dans la première période.

Selon un mode de réalisation, lesdits états passants des deuxième et premier transistors court-circuitent leurs diodes intrinsèques respectives.

Selon un mode de réalisation, chaque transistor est associé à une diode en antiparallèle court-circuitée pendant lesdits états passants.

Selon un mode de réalisation, des deuxièmes périodes d'application de la commande en créneaux au deuxième interrupteur et d'état passant du premier interrupteur débutent par lesdits franchissements du deuxième seuil.

Selon un mode de réalisation, chaque créneau de la commande provoque un autre franchissement du deuxième seuil par la tension aux bornes du deuxième interrupteur, et chaque deuxième période se termine à un délai prédéfini après un dernier desdits autres franchissements du deuxième seuil situés dans la deuxième période.

Selon un mode de réalisation, le procédé prévoit, entre les premières périodes et les deuxièmes périodes, des troisièmes périodes de mise à l'état bloqué des deux interrupteurs.

Selon un mode de réalisation, lesdites tensions aux bornes des premier et deuxième interrupteurs sont référencées par rapport à leur une borne de source commune, et les franchissements sont des passages depuis des valeurs absolues inférieures aux premier et deuxième seuils de tension respectifs vers des valeurs absolues supérieures, lesdits premier et deuxième seuil étant de préférence de même valeur.

Selon un mode de réalisation, les premier et deuxième interrupteurs comprennent des transistors à effet de champ, de préférence de type HEMT GaN.

Un mode de réalisation prévoit un circuit configuré pour mettre en œuvre un procédé décrit.

Selon un mode de réalisation, le circuit comprend :
- un premier comparateur recevant ladite tension aux bornes du premier interrupteur et ledit premier seuil de tension, et un circuit logique adapté à mémoriser ledit un ou plusieurs franchissements et relié à la sortie du comparateur ; et
- un deuxième comparateur recevant ladite tension aux bornes du deuxième interrupteur et ledit deuxième seuil de tension, et un circuit logique supplémentaire adapté à mémoriser ledit un ou plusieurs franchissements supplémentaire et relié à la sortie du deuxième comparateur.

Selon un mode de réalisation, le circuit comprend :
- un premier circuit monostable ayant une entrée reliée à la sortie dudit comparateur ; et
- de préférence, un deuxième circuit monostable supplémentaire ayant une entrée reliée à la sortie dudit deuxième comparateur.

Selon un mode de réalisation, le premier circuit monostable comprend un compteur à bascules configuré pour recevoir la commande en créneaux sur une entrée d'horloge.

Un mode de réalisation prévoit un dispositif monolithique comprenant un circuit tel que décrit et, de préférence, les premier et deuxième interrupteurs.

Un mode de réalisation prévoit un convertisseur à découpage configuré pour recevoir et/ou fournir une tension alternative, comprenant un ou plusieurs circuits tels que décrits ou un dispositif tels que décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique, un exemple de convertisseur à découpage d'un type auquel s'appliquent les modes de réalisation décrits ;
la figure 2 représente, de manière partielle et schématique, un exemple de branche de pont de convertisseur à découpage, d'un type auquel s'appliquent les modes de réalisation décrits ;
la figure 3 représente, par une vue en coupe schématique, un exemple d'interrupteur bidirectionnel d'un type auquel s'appliquent les modes de réalisation décrits ;
la figure 4 représente, de manière schématique, un mode de réalisation d'un dispositif comprenant un circuit de commande et des interrupteurs électriquement en série commandés par le circuit ;
la figure 5 représente, par des chronogrammes schématiques, un mode de réalisation d'un procédé mis en œuvre par le circuit de la figure 4 ; et
la figure 6 représente, de manière schématique, un exemple d'un mode de réalisation d'un circuit monostable du circuit de commande de la figure 4.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, un circuit d'attaque (en anglais "driver"), dit aussi circuit de commande rapprochée, prévu pour appliquer une commande à un interrupteur bidirectionnel (c'est-à-dire appliquer une tension à une électrode de contrôle ou borne de commande telle qu'une grille de transistor formant l'interrupteur), n'est pas décrit en détail, les modes de réalisation décrits étant compatibles avec les circuits de commande rapprochée usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

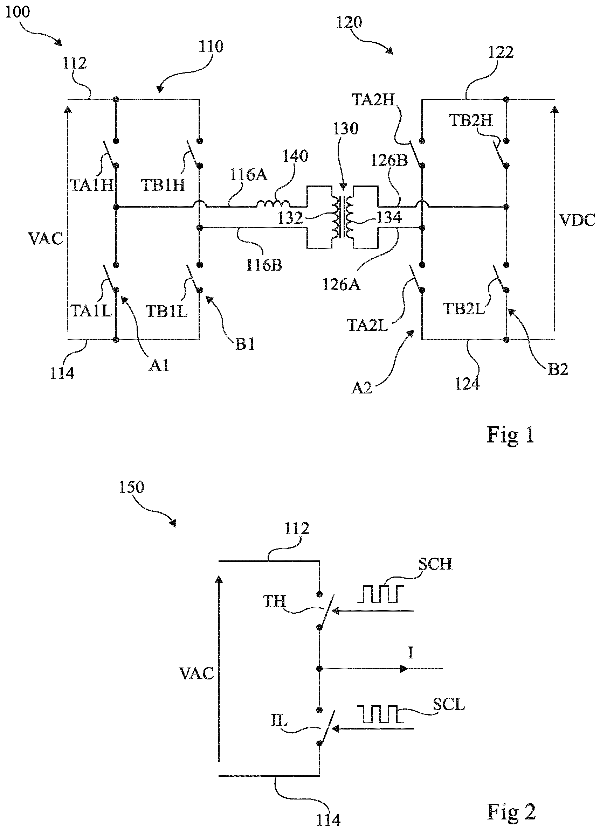

La figure 1 représente, de manière schématique, un exemple de convertisseur à découpage 100 d'un type auquel s'appliquent les modes de réalisation décrits. Dans cet exemple particulier, le convertisseur 100 est identique ou similaire aux convertisseurs décrits dans la demande de brevet EP3346598 (B15653-DD17624).

Le convertisseur 100 est un convertisseur de type alternatif-continu AC-DC (de l'anglais "alternating current-direct current"), recevant une tension alternative VAC et fournissant une tension continue VDC. Dans une application typique, la tension alternative VAC provient d'un réseau de distribution électrique, et a par exemple une tension efficace de l'ordre d'environ 110 V ou d'environ 230 V, et par exemple une fréquence égale à 60 Hz ou 50 Hz. La tension alternative VAC est ainsi, de préférence, une tension élevée, c'est-à-dire de valeur crête supérieure à 100 V, de préférence supérieure à 150 V, par exemple égale à environ 155 V ou à environ 325 V.

La tension continue VDC est typiquement utilisée pour charger une batterie, par exemple une batterie d'un ordinateur portable ou d'un dispositif mobile de communication à distance tel qu'un téléphone mobile. Dans une application, la tension continue est fournie par l'intermédiaire d'une prise selon le standard de bus universel en série USB (en anglais "Universal Serial Bus"), par exemple de type C, préférentiellement au standard de livraison d'énergie PD (en anglais "Power Delivery"). La tension continue VDC est alors de 5 V, 12 V ou 20 V. La puissance délivrée peut alors aller jusqu'à 100 W. Dans d'autres applications, la tension continue VDC alimente des équipements d'un centre de données (en anglais "data center"), tels que des microprocesseurs, des mémoires de masse, des routeurs, etc. La tension continue peut alors être de 12 V, 24 V, ou 48 V, et la puissance peut être supérieure à 1 kW, par exemple égale à environ 1,5 kW ou 3 kW. Plusieurs convertisseurs peuvent être disposés en parallèle pour fournir la même tension continue.

Le convertisseur 100 comprend quatre interrupteurs TA1H, TA1L, TB1H, TB1L, par exemple identiques à des dispersions de fabrication près. Les interrupteurs TA1H, TA1L, TB1H, TB1L sont connectés de manière à former un premier pont en H 110. Le premier pont en H 110 comprend deux branches A1 et B1 reliant des nœuds 112 et 114 d'application de la tension alternative VAC. La branche A1 comprend les interrupteurs TA1H et TA1L électriquement en série entre les nœuds 112 et 114. La branche B1 comprend les interrupteurs TB1H et TB1L électriquement en série entre les nœuds 112 et 114. Les interrupteurs TA1H et TB1H sont situés du côté du nœud 112 et les interrupteurs TA1L et TB1L sont situés du côté du nœud 114. Le pont en H 110 comprend un nœud 116A de connexion entre les interrupteurs TA1H et TA1L et un nœud 116B de connexion entre les interrupteurs TB1H et TB1L.

Le convertisseur 100 comprend en outre quatre interrupteurs TA2H, TA2L, TB2H, TB2L, par exemple identiques à des dispersions de fabrication près. Les interrupteurs TA2H, TA2L, TB2H, TB2L sont connectés de manière à former un deuxième pont en H 120. Le deuxième pont en H 120 comprend deux branches A2 et B2 reliant des nœuds 122 et 124 de fourniture de la tension continue VDC. La branche A2 comprend les interrupteurs TA2H et TA2L électriquement en série entre les nœuds 122 et 124. La branche B2 comprend les interrupteurs TB2H et TB2L électriquement en série entre les nœuds 122 et 124. Les interrupteurs TA2H et TB2H sont situés du côté du nœud 122 et les interrupteurs TA2L et TB2L sont situés du côté du nœud 124. Le pont en H 120 comprend un nœud 126A de connexion entre les interrupteurs TA2H et TA2L et un nœud 126B de connexion entre les interrupteurs TB2H et TB2L.

Le convertisseur 100 comprend en outre un transformateur 130. Le transformateur 130 a un premier enroulement 132 électriquement en série avec une inductance 140 entre les nœuds 116A et 116B du premier pont en H 110. Le transformateur 130 a un deuxième enroulement 134 reliant, de préférence connectant, les nœuds 126A et 126B du deuxième pont en H 120. En variante, le premier enroulement 132 connecte les nœuds 116A et 116B, et l'inductance 140 est en série avec le deuxième enroulement 134 entre les nœuds 126A et 126B. Dans une autre variante, l'inductance 140 représente une inductance de fuite du transformateur 130, c'est-à-dire que le transformateur 130 a un coefficient de couplage strictement inférieur à 1.

En fonctionnement, la tension alternative prend successivement des valeurs positives (potentiel du nœud 112 supérieur à celui du nœud 114) et négatives (potentiel du nœud 112 inférieur à celui du nœud 114). Pour assurer ce fonctionnement, les interrupteurs TA1H, TA1L, TB1H, TB1L sont bidirectionnels en tension. Un interrupteur bidirectionnel en tension est défini par un interrupteur apte, à un état bloqué, à empêcher le passage d'un courant pour les deux sens, ou signes, de la tension aux bornes de l'interrupteur.

En outre, le courant circulant dans l'inductance 140 est également alternatif. Pour cela, les interrupteurs sont bidirectionnels en courant. Un interrupteur bidirectionnel en courant est défini par un interrupteur apte, à un état passant, à permettre le passage d'un courant dans les deux sens. Ainsi, les interrupteurs TA1H, TA1L, TB1H, TB1L sont bidirectionnels en tension et en courant.

Dans un exemple de fonctionnement, à une fréquence de découpage, on rend alternativement les interrupteurs bidirectionnels TA1H et TB1L passants et les interrupteurs bidirectionnels TB1H et TA1L bloqués, puis les interrupteurs bidirectionnels TA1H et TB1L bloqués et les interrupteurs bidirectionnels TB1H et TA1L passants. Dans cet exemple, chaque branche A1 et B1 est commandée de la manière décrite ci-après en relation avec la figure 2. Cet exemple n'est pas limitatif, les modes de réalisation décrits étant compatibles avec les procédés usuels de commande d'interrupteurs de convertisseur AC-DC à découpage. Ces procédés usuels de commande des divers interrupteurs d'un convertisseur, notamment des interrupteurs bidirectionnels, pour obtenir par découpage, par exemple, une tension continue à partir d'une tension alternative, ne sont pas décrits en détail. La fréquence de découpage est plus élevée que celle de la tension alternative, de préférence supérieure à 1 MHz.

L'exemple du convertisseur 100 décrit ci-dessus n'est pas limitatif. En particulier, les modes de réalisation décrits sont applicables à tout convertisseur similaire au convertisseur 100 destiné à recevoir et/ou fournir une tension alternative. Les modes de réalisation décrits sont également applicables à tout convertisseur à découpage, en particulier à tout convertisseur destiné à recevoir et/ou fournir une tension ayant des signes successifs différents, préférentiellement une tension alternative monophasée ou multiphasée. En particulier, les modes de réalisation sont applicables à tout convertisseur comprenant une ou plusieurs branches entre deux nœuds d'application de la tension alternative. Chaque branche comprend alors au moins deux interrupteurs en série. Les branches fournissent typiquement un courant à une inductance interne au convertisseur. De préférence, ces interrupteurs sont bidirectionnels. Par bidirectionnel, on entend bidirectionnel en courant et/ou en tension.

La figure 2 représente, de manière partielle et schématique, un exemple de branche 150 d'un convertisseur à découpage, d'un type auquel s'appliquent les modes de réalisation décrits.

La branche 150 peut constituer l'une et/ou l'autre des branches A1 et B1 de l'exemple du convertisseur 100 de la figure 1. Ainsi, la branche 150 comprend deux interrupteurs bidirectionnels TH et TL en série entre les nœuds 112 et 114. Les interrupteurs bidirectionnels TH et TL peuvent constituer les interrupteurs respectifs TA1H et TA1L ou les interrupteurs respectifs TB1H et TB1L du convertisseur 100 de la figure 1. Ceci n'est pas limitatif, la branche 150 pouvant être toute association de deux interrupteurs TH et TL électriquement en série définissant une cellule de commutation d'un convertisseur recevant et/ou fournissant une tension alternative.

Par cellule de commutation, on entend que des signaux SCH et SCL de commande des interrupteurs respectifs TH et TL sont de telle sorte que, lorsque l'un des interrupteurs TH et TL est passant, l'autre des interrupteurs TH et TL est bloqué. Ainsi, les interrupteurs TH et TL ne sont pas passants simultanément. Au cours de commutations de la cellule, les états passants et bloqués des interrupteurs TH et TL sont échangés.

Les interrupteurs TH et TL peuvent aussi être bloqués simultanément, en particulier à chaque commutation au cours de périodes dites de temps mort. De préférence, afin d'éviter des pertes d'énergie dans les interrupteurs TH et TL lors des commutations, à la fin de chaque temps mort, la mise à l'état passant de l'interrupteur concerné est effectuée lorsque la tension aux bornes de cet interrupteur s'annule, ou s'annule sensiblement par rapport à la valeur crête de la tension VAC. De telles commutations sont appelées commutations à tension nulle ZVS (en anglais "Zéro Volt Switching"). Les modes de réalisation sont compatibles avec les procédés usuels de commutation ZVS.

Les interrupteur TH et TL reçoivent les signaux de commande respectifs SCH et SCL. Les signaux de commande SCH et SCL sont typiquement en créneaux. Par signal en créneaux, on entend un signal comprenant une succession de cycles, chaque cycle comprenant une partie à un niveau bas du signal et une partie à un niveau haut du signal. Les cycles des signaux SCH et SCL peuvent être répétés à la fréquence de découpage.

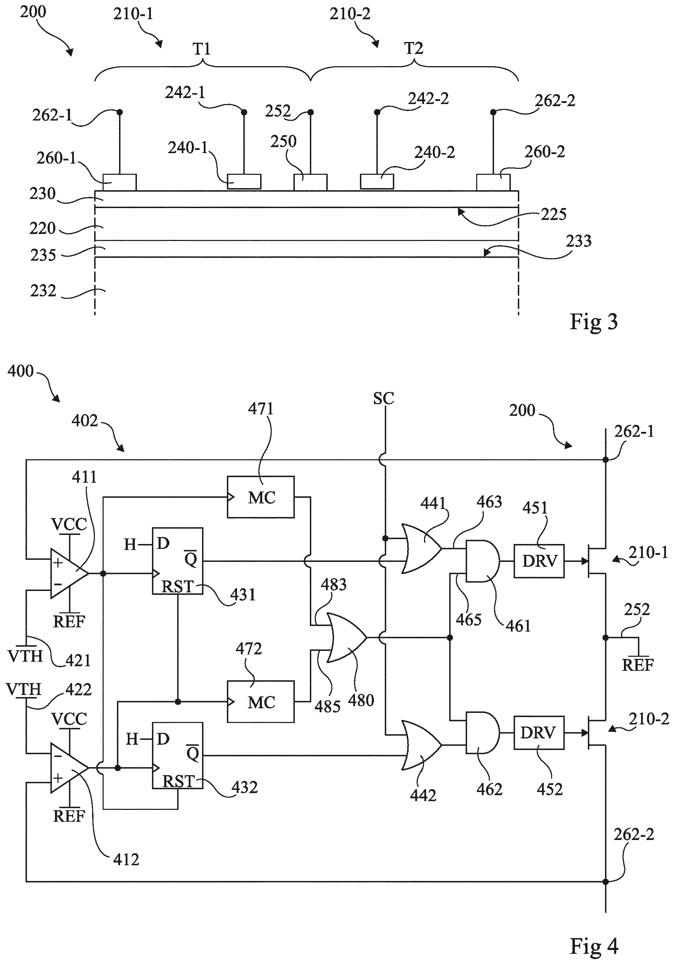

La figure 3 représente, par une vue en coupe schématique, un exemple d'interrupteur bidirectionnel 200 d'un type auquel s'appliquent les modes de réalisation décrits. L'interrupteur bidirectionnel 200 peut constituer tout interrupteur bidirectionnel d'un convertisseur à découpage tel que décrit en relation avec la figure 1, ou tout interrupteur bidirectionnel d'une cellule de commutation. Par exemple, les interrupteurs TA1H, TA1L, TB1H et TBA1L du convertisseur 100 de la figure 1 sont chacun identique ou similaire à l'interrupteur bidirectionnel 200.

L'interrupteur bidirectionnel 200 comprend deux interrupteurs 210-1 et 210-2 électriquement en série. De préférence, les interrupteurs 210-1 et 210-2 comprennent des transistors à effet de champ respectifs T1 et T2, préférentiellement de même type. Les transistors T1 et T2 peuvent être de tout type à effet de champ. Cependant, préférentiellement, les transistors T1 et T2 sont du type représenté, dit transistor à haute mobilité électronique, HEMT (de l'anglais "High Electron-Mobility Transistor"). De tels transistors comprennent deux couches semiconductrices 220 et 230 ayant des bandes interdites différentes, et définissant entre elles une interface 225 le long de laquelle les électrons sont mobiles (la couche 230 recouvrant la couche 220). Un tel transistor permet de bloquer des tensions plus élevées et permet des commutations plus rapides que d'autres types de transistors à effet de champ. Plus préférentiellement, les semiconducteurs des couches 220 et 230 sont respectivement du nitrure de gallium GaN et du nitrure d'aluminium-gallium AlGaN. On parle alors de transistor de type HEMT GaN.

Les couches 220 et 230 reposent typiquement sur un support 232. Typiquement, le support 232 comprend, ou est constitué par, un substrat formé d'une portion de tranche (en anglais "wafer") semiconductrice, telle qu'une tranche de silicium. Plus précisément, les couches 220 et 230 reposent sur une face 233 du support 232 (face supérieure en figure 2, dite aussi face avant). Le support 232 peut être recouvert de couches tampon 235, situées entre le support 232 et la couche 220, et destinées à faciliter la formation de la couche 220 sur le support 232. Divers éléments, tels que des régions isolantes, ainsi que les matériaux autres que ceux décrits ci-dessus, et des dimensions telles que les épaisseurs des couches, ne sont pas détaillés ici, les modes de réalisation décrits étant compatibles avec les transistors HEMT GaN usuels.

Bien que, dans l'exemple représenté, chaque interrupteur 210-1, 210-2 comprenne seulement un transistor, respectivement T1, T2, l'interrupteur 210-1 peut comprendre plusieurs transistors T1 électriquement en parallèle les uns des autres, et l'interrupteur 210-2 peut comprendre plusieurs transistors T2 électriquement en parallèle les uns des autres.

Les transistors T1 et T2 comprennent chacun une grille, respectivement 240-1, 240-2, et une région de drain, respectivement 260-1, 260-2. Dans l'exemple représenté, les grilles et les régions de drain sont situées sur la couche 230.

Les transistors T1 et T2 comprennent chacun une borne, respectivement 242-1, 242-2, reliée, de préférence connectée, aux grilles respectives 240-1 et 240-2. Les bornes 242-1 et 242-2 constituent des bornes de commande des interrupteurs respectifs 210-1 et 210-2. Les transistors T1 et T2 comprennent chacun une borne, respectivement 262-1, 262-2 reliée, de préférence connectée, à la région de drain, respectivement 260-1, 260-2. Les bornes 262-1, 262-2 forment les bornes de conduction de l'interrupteur bidirectionnel 200.

De préférence, l'interrupteur bidirectionnel 200 comprend une borne de source 252 commune aux transistors T1 et T2, connectée à une région de source 250 commune aux transistors T1 et T2. Dans l'exemple représenté, la région de source commune 250 est située sur la couche 230. Dans chaque transistor T1, T2, la grille, respectivement 240-1, 240-2, est située entre la région de drain, respectivement 260-1, 260-2, et la région de source commune 250. Dans une variante, la borne commune de source 252 est reliée, par exemple connectée, à des régions de source distinctes dans les transistors T1 et T2. Dans une autre variante, les transistors T1 et T2 ont des bornes de source distinctes.

Chaque transistor T1, T2 est configuré pour que, lorsqu'une tension positive est appliquée entre le drain et la source du transistor, l'état passant/bloqué du transistor est commandé par la tension entre la grille et la source du transistor. Ainsi, lorsque la tension prend des valeurs élevées telles que définies ci-dessus, la majeure partie de cette tension est entre le drain et la grille.

De préférence, comme ceci est représenté, les structures des interrupteurs 210-1 et 210-2 constituées par les couches 220 et 230, les grilles 240-1, 240-2 et les régions de drain 260-1, 260-2 et de source 250, sont symétriques l'une de l'autre par rapport à un plan ou par rapport à un axe passant par la région de source commune 250. Par symétrique, on entend symétrique à des dispersions de fabrication près. Ceci permet, par rapport à des interrupteurs 210-1 et 210-2 non symétriques, d'obtenir plus facilement dans et/ou sur un même support 232 plusieurs interrupteurs bidirectionnels 200 à région de source commune ayant des caractéristiques électriques identiques.

La figure 4 représente, de manière schématique, un exemple d'un mode de réalisation d'un dispositif 400 comprenant un circuit de commande 402 et des interrupteurs 210-1 et 210-2 électriquement en série commandés par le circuit 402.

Un convertisseur tel que décrit en relation avec la figure 1 peut comprendre plusieurs dispositifs 400 identiques ou similaires à l'exemple représenté. Pour chacun de ces dispositifs 400, les interrupteurs en série 210-1 et 210-2 constituent alors, de préférence, un interrupteur bidirectionnel 200 du convertisseur. Par exemple, ces interrupteurs bidirectionnels constituent les interrupteurs respectifs TA1H, TB1H, TA1L et/ou TB1L d'un convertisseur du type du convertisseur 100 de la figure 1. Chaque dispositif 400 reçoit alors un signal de commande SC, ou commande SC, représentatif d'un état souhaité de l'interrupteur bidirectionnel concerné. Les signaux de commande SC peuvent être différents pour les différents dispositif 400. Par exemple, la commande SC correspond au signal SCH ou SCL de la branche 150 de la figure 2.

De préférence, les interrupteurs en série 210-1 et 210-2 du dispositif 400 sont identiques ou similaires aux interrupteurs 210-1 et 210-2 et l'interrupteur bidirectionnel 200 est du type décrit en relation avec la figure 3.

De préférence, le circuit de commande 402 est monolithique. Par circuit ou dispositif monolithique, on entend que le circuit ou le dispositif est formé dans et sur un même substrat, par exemple une même portion de tranche ou plaquette semiconductrice. Un tel circuit monolithique présente, par rapport à un circuit non monolithique, l'avantage de pouvoir être connecté ou relié à un interrupteur bidirectionnel, à une branche de pont en H, ou à un pont en H monolithique, d'une manière plus simple et plus rapprochée, donc moins susceptible d'être perturbée par des parasites.

Le circuit de commande 402 peut être compris dans un boîtier de circuit intégré (non représenté). Par boîtier de circuit intégré, on entend un composant, de préférence étanche, d'où sortent des plages de connexion ou des broches de connexion à des circuits électroniques extérieurs au boîtier, par exemple à un circuit imprimé, PCB (en anglais "Printed Circuit Board").

De préférence, le boîtier de circuit intégré contient, outre le circuit de commande 402, l'ensemble du dispositif 400. Le boîtier peut en outre contenir plusieurs dispositifs 400, par exemple deux dispositifs 400 d'une cellule de commutation ou quatre dispositifs 400 d'un pont en H. Le dispositif 400 peut également être monolithique. Plusieurs dispositifs 400 peuvent former un ensemble monolithique. Ceci permet de simplifier la réalisation d'un convertisseur comprenant de telles cellules de commutation et/ou ponts en H.

Le circuit de commande 402 est, de préférence, référencé par rapport au potentiel REF d'une borne de source 252 commune aux interrupteurs 210-1 et 210-2, par exemple telle que celle décrite en relation avec la figure 3. Le circuit 402 peut être alimenté par une tension VCC référencée au potentiel REF (représentée seulement pour deux comparateurs 411 et 412 du circuit 402). Par tension référencée au potentiel REF, on entend que la différence entre le potentiel d'un nœud d'application de cette tension et le potentiel REF est égale à cette tension.

Un avantage du circuit de commande 402 référencé par rapport au potentiel REF est qu'aucune isolation galvanique n'est requise dans le circuit 402, et que le circuit 402 peut être relié seulement à l'interrupteur bidirectionnel 200 et à un élément fournissant la commande SC. La mise en œuvre de la commande de l'interrupteur bidirectionnel 200 est alors particulièrement simple.

Le comparateur 411 a une entrée, par exemple non inverseuse (+), reliée, de préférence connectée, à la borne de drain 262-1 de l'interrupteur 210-1. Le comparateur 411 a une autre entrée, inverseuse (-) dans cet exemple, reliée, de préférence connectée, à un nœud 421 d'application d'une tension VTH référencée par rapport au potentiel REF. Autrement dit, le comparateur 411 reçoit la tension aux bornes de l'interrupteur 210-1 et compare cette tension reçue à la tension VTH. Plus précisément, la tension aux bornes de l'interrupteur 210-1 est ici entre les bornes de conduction, (le drain et la source) de l'interrupteur 210-1.

La tension VTH constitue un seuil de tension. Ce seuil a de préférence une valeur fixe, c'est-à-dire constante, et positive. Ainsi, lorsque la tension aux bornes de l'interrupteur 210-1 passe d'une valeur positive inférieure au seuil VTH à une valeur positive supérieure au seuil VTH, c'est-à-dire lorsque cette tension franchit la tension de seuil VTH, l'état du comparateur 411 bascule. Le comparateur 411 peut être constitué de tout circuit apte à détecter un franchissement du seuil VTH par la tension aux bornes de l'interrupteur 210-1.

Le circuit de commande 402 comprend en outre une bascule 431 de type D. Par bascule de type D, on entend une bascule ayant une entrée D de donnée, une sortie non inversée Q (non représentée en figure 4) et/ou une sortie inversée Q̅, et une entrée d'horloge. La bascule 431 a en outre une entrée RST asynchrone de remise à zéro, qui, lorsqu'elle est activée, met la sortie non inversée Q à un niveau logique bas et la sortie inversée Q̅ à un niveau logique haut.

L'entrée d'horloge de la bascule 431 est reliée, de préférence connectée, à la sortie du comparateur 411. La bascule 431 peut alors mémoriser chaque franchissement du seuil VTH par la tension aux bornes de l'interrupteur 210-1. Pour cela, à titre d'exemple, l'entrée de donnée D reçoit un niveau logique haut (H). Ainsi, un franchissement du seuil VTH fait passer la sortie inversée Q̅ au niveau logique bas. Ce niveau logique bas est conservé après le franchissement du seuil tant que l'entrée RST n'est pas activée. La bascule 431 peut être remplacée par tout circuit logique adapté à mémoriser un franchissement de seuil par le comparateur 411 et pouvant être remis à zéro ou réinitialisé.

Le circuit de commande 402 comprend une porte logique OU 441 ayant une entrée reliée, de préférence connectée, à la sortie inversée Q̅ de la bascule 431. Une autre entrée de la porte logique OU 441 reçoit la commande SC.

Le circuit de commande 402 comprend un circuit de commande rapprochée 451 (DRV) ayant une entrée reliée à la sortie de la porte logique OU 441, par l'intermédiaire d'une porte logique ET 461 dans l'exemple représenté. La porte logique ET 461, optionnelle, a une entrée 463 reliée ou connectée à la sortie de la porte logique OU 441 et une sortie reliée à l'entrée du circuit de commande rapprochée 451. En l'absence de la porte logique ET 461, l'entrée du circuit de commande rapprochée 451 peut être reliée d'une autre manière, ou être connectée, à la sortie de la porte logique OU 441. Le circuit de commande rapprochée 451 commande l'interrupteur 210-1.

Ainsi, la porte logique OU 441 et le circuit de commande rapprochée 451 ont pour fonction, lorsque la liaison entre la porte logique OU 441 et le circuit 451 transmet le niveau logique de sortie de la porte logique OU 441, de :
- mettre l'interrupteur 210-1 à l'état passant lorsqu'aucun franchissement du seuil VTH par la tension aux bornes de l'interrupteur 210-1 n'est mémorisé par la bascule 431 ; et
- appliquer la commande SC à l'interrupteur 210-1 lorsqu'un franchissement de seuil est mémorisé par la bascule 431.

La porte logique OU 441 et le circuit 451 peuvent être remplacés par tout circuit logique adapté à avoir cette fonction.

De préférence, le circuit de commande 402 comprend, outre le comparateur 412, une bascule 432, une porte logique OU 442, un circuit de commande rapprochée 452, et une éventuelle porte logique ET 462, identiques ou similaires respectivement au comparateur 411, à la bascule 431, à la porte logique OU 441, au circuit de commande rapprochée 451, et à l'éventuelle porte logique ET 461, agencés entre eux de manière identique ou similaire. Ces éléments ne sont pas décrits à nouveau en détail.

Dans cet exemple, l'entrée non inverseuse (+) du comparateur 412 est reliée, de préférence connectée, à la borne de drain 262-2 de l'interrupteur 210-2. L'entrée inverseuse (-) du comparateur 412 est reliée à un nœud 422 d'application d'une tension référencée par rapport au potentiel REF. Cette tension est, de préférence, égale au seuil VTH, mais peut, en variante, avoir une valeur différente. La porte logique OU 442 reçoit la commande SC. Le circuit de commande rapprochée 452 commande l'interrupteur 210-2.

Ainsi, le comparateur 412, la bascule 432, la porte logique OU 442, et le circuit de commande rapprochée 452 ont, pour l'interrupteur 210-2, les mêmes fonctions que le comparateur 411, la bascule 431, la porte logique OU 441, et le circuit de commande rapprochée 451 pour l'interrupteur 210-1. La porte logique OU 442 et/ou la bascule 432 peuvent être remplacés de la même manière que, respectivement, la porte logique OU 441 et/ou la bascule 431, par tout autre circuit apte à remplir les mêmes fonctions, décrites ci-dessus.

De préférence, l'entrée RST de la bascule 431 est reliée, plus préférentiellement connectée, à la sortie du comparateur 412. Également, de préférence, l'entrée RST de la bascule 432 est reliée, plus préférentiellement connectée, à la sortie du comparateur 411. Autrement dit, de préférence, pour chacun des deux interrupteurs 210-1 et 210-2, l'entrée RST de la bascule associée à cet interrupteur est reliée, plus préférentiellement connectée, à la sortie du comparateur associé à l'autre des deux interrupteurs 210-1 et 210-2. Il en résulte que, pour chacun des deux interrupteurs 210-1 et 210-2, le franchissement du seuil par la tension aux bornes de cet interrupteur provoque la remise à zéro de la bascule mémorisant le franchissement du seuil par la tension aux bornes de l'autre des deux interrupteurs 210-1 et 210-2.

Selon un mode de réalisation, le circuit de commande 402 comprend en outre un circuit monostable (MC) 471 redéclenchable. Le circuit monostable 471 a une entrée de déclenchement reliée, de préférence connectée, à la sortie du comparateur 411. Le circuit monostable 471 peut avoir sa sortie reliée à une entrée 465 de la porte logique ET 461, par une porte logique OU 480 dans l'exemple représenté. La porte logique OU 480, optionnelle, a une sortie reliée, de préférence connectée, à l'entrée 465 de la porte logique ET 461 et une entrée 483 reliée, de préférence connectée, à la sortie du circuit monostable 471. Le circuit monostable 471 peut être du type commercialisé par la société Texas Instruments sous la dénomination commerciale "NE555".

Le circuit de commande 402 peut également comprendre un circuit monostable 472, de préférence identique ou similaire au circuit monostable 471. Le circuit monostable 472 a une entrée reliée, de préférence connectée, à la sortie du comparateur 412 et une sortie reliée, de préférence connectée, à une entrée 485 de la porte logique OU 480.

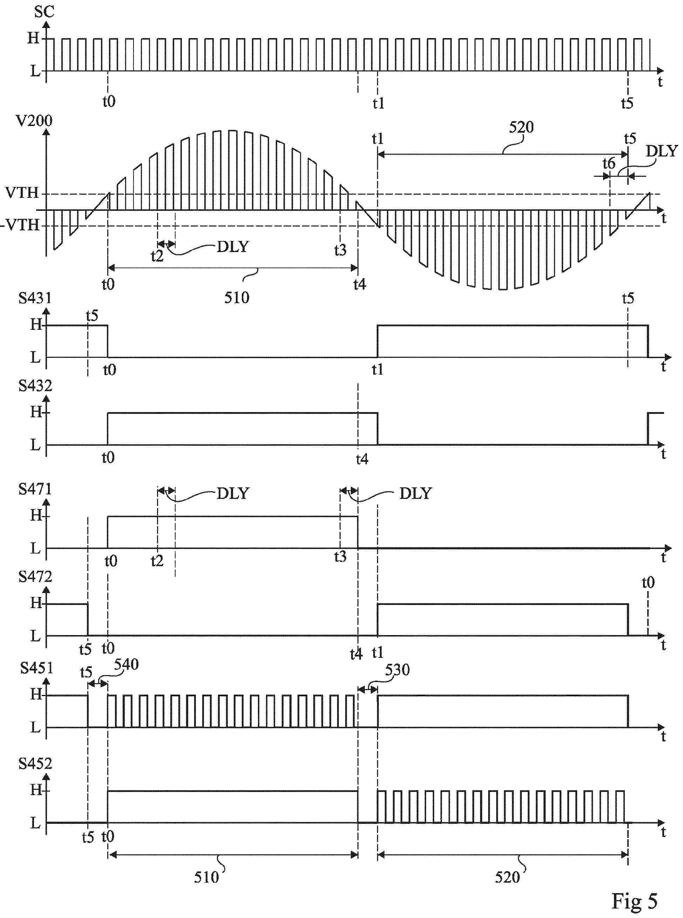

La figure 5 représente, par des chronogrammes schématiques, un exemple d'un mode de réalisation d'un procédé mis en œuvre par le circuit de commande 402 de la figure 4. En particulier, le procédé est ici représenté dans le cas préféré où le dispositif 400 de la figure 4 comprend les circuits monostables 471 et 472, la porte logique OU 480 et les portes logiques ET 461 et 462, et est utilisé dans une branche de pont d'un convertisseur telle que la cellule de commutation 150 de la figure 2 recevant une tension alternative VAC. Plus précisément, on a représenté, en fonction du temps t, des allures schématiques :
- de la commande SC de l'interrupteur bidirectionnel 200 ;
- d'une tension V200 aux bornes de l'interrupteur bidirectionnel 200, c'est-à-dire entre les bornes de drain 262-1 et 262-2 (figure 4) ;
- de signaux S431 et S432 fournis par les bascules respectives 431 et 432 (figure 4) sur leurs sorties inversées Q̅ ;
- de signaux S471 et S472 fournis par les circuits monostables respectifs 471 et 472 (figure 4) ; et
- de signaux S451 et S452 appliqués aux interrupteurs respectifs 210-1, 210-2 par les circuits de commande rapprochée respectifs 451 et 452 (figure 4). Les niveaux haut (H) et bas (L) du signal S451 correspondent aux états respectifs passant et bloqué de l'interrupteur 210-1, et les niveaux haut et bas du signal S452 correspondent aux états respectifs passant et bloqué de l'interrupteur 210-2.

Dans cet exemple, la commande SC est en créneaux entre un niveau haut (H) et un niveau bas (L). La tension alternative VAC aux bornes de la branche de pont est sinusoïdale et présente des demi-alternances définies chacune par une période de temps entre deux changements consécutifs de signe de la tension alternative VAC. Par souci de lisibilité, le rapport représenté entre la fréquence des créneaux de la commande SC (fréquence de découpage) et la fréquence de la tension alternative VAC, est réduit par rapport aux rapports typiques entre ces fréquences.

Lorsque la tension V200 est positive (potentiel de la borne 262-1 supérieur à celui de la borne 262-2), la tension V200 se retrouve aux bornes de l'interrupteur 210-1 (éventuellement à une chute de tension près dans une diode parasite, non représentée, de l'interrupteur 210-2, située en parallèle entre les bornes de cet interrupteur). Ceci se produit au cours des alternances positives de la tension alternative VAC (tension VAC positive).

De la même manière, lorsque la tension V200 est négative, la tension V200 se retrouve en valeur absolue aux bornes de l'interrupteur 210-2. Ceci se produit au cours des alternances négatives de la tension alternative.

A un instant t0, au cours de chaque alternance positive, la tension V200 franchit le seuil VTH. Il en résulte la mise à l'état bas du signal S431 et la remise à zéro de la bascule 432. Le signal S432 passe à l'état haut, ce qui provoque la mise à l'état passant de l'interrupteur 210-2. Ainsi, le franchissement du seuil VTH par la tension aux bornes de l'interrupteur 210-1 provoque l'état passant de l'interrupteur 210-2. Une période de temps 510 débute à l'instant t0, pendant laquelle l'interrupteur 210-2 est à l'état passant. Plus précisément, l'interrupteur 210-2 reste à l'état passant pendant toute la période 510.

On aurait pu penser laisser l'interrupteur 210-2 à l'état bloqué pendant les alternances positives lorsque l'interrupteur 210-1 est passant. Il en aurait résulté une chute de tension dans la diode parasite. On aurait également pu penser laisser l'interrupteur 210-2 à l'état bloqué pendant les alternances positives lorsque l'interrupteur 210-1 est bloqué. Il en aurait résulté que la référence de potentiel REF aurait été flottante par rapport à la tension V200, c'est-à-dire qu'aucun potentiel défini par rapport à la tension V200 ne serait appliqué à la borne de source commune.

En comparaison, le fait de prévoir la mise à l'état passant de l'interrupteur 210-2 lorsque la tension aux bornes de l'interrupteur 210-1 franchit le seuil VTH permet d'améliorer à la fois le rendement et la fiabilité du convertisseur. Ceci provient du fait que :
- on évite ou réduit les pertes d'énergie résultant de chutes de tensions dans les diodes, et
- on évite ou réduit diverses accumulations de charges sous les transistors T1 et T2 (figure 3) constituant les interrupteurs 210-1 et 210-2. Ces accumulations de charge sont susceptibles de modifier les seuils de tension grille-source au-delà desquels les transistors sont passants et/ou d'augmenter la résistance à l'état passant des transistors, ce qui nuit au rendement et à la fiabilité du convertisseur.

Les diodes parasites mentionnées ci-dessus correspondent, en pratiques, aux diodes intrinsèques présentes dans tout transistor à effet de champ, à base de Silicium, de carbure de silicium, transistor de type HEMT Gan. Les transistors de ces types ont, de par la présence de cette diode intrinsèque, la possibilité de conduire naturellement en inverse même lorsqu'il est commandé à l'état bloqué. Ce mode de conduction dégradé (faible état passant) peut être réduit mais est inévitable dans ces technologies. Grâce à la mise en conduction de l'interrupteur 210-2 pendant les alternances positives et à la mise en conduction du transistor 210-1 pendant les alternances négatives, on évite ou réduit les pertes dans ces diodes.

Dans d'autres technologies comme les transistors IGBT, ce mode de conduction intrinsèque n'est pas présent mais des diodes connectées en antiparallèles peuvent être présentes. Là encore, avec le mode de commande prévu, on évite les pertes dans ces diodes.

Afin que le franchissement de seuil par la tension V200 ait lieu, le seuil VTH est inférieur à la valeur crète de la tension alternative VAC. De préférence, le seuil VTH est inférieur à 5 % de la tension crète, plus préférentiellement inférieur à 1 % de la tension crète. A titre d'exemple, le seuil VTH est inférieur à 30 V, par exemple inférieur à 4 V. Plus le seuil VTH est faible, plus la période 510 débute tôt à chaque alternance positive, ce qui augmente le rendement et de fiabilité.

De préférence, le seuil VTH est supérieur à 0,1 % de la tension crète, plus préférentiellement supérieur à 0,5 % de la tension crète. A titre d'exemple, le seuil VTH est supérieur à 0,4 V, de préférence supérieur à 2 V. Le seuil VTH est ainsi supérieur à une tension présentée par l'interrupteur 210-1 lorsque celui-ci est à l'état passant. Ceci permet d'éviter de faussement détecter des franchissements de seuil lorsque l'interrupteur 210-1 est à l'état passant.

Dans un mode de réalisation où le circuit de commande 402 (figure 4) comprend le comparateur 412, la bascule 432, et la porte logique OU 442, le franchissement du seuil VTH à un instant t1 par la tension aux bornes de l'interrupteur 210-2 (correspondant au franchissement du seuil -VTH par la tension V200) provoque la mise à l'état passant de l'interrupteur 210-1 pendant une période de temps 520. Ceci se produit d'une manière similaire à celle, décrite ci-dessus, de provoquer la mise à l'état passant de l'interrupteur 210-2 pendant la période 510 au franchissement du seuil VTH par la tension aux bornes de l'interrupteur 210-1.

Dans une variante, le comparateur 412, la bascule 432 et la porte logique OU 442 ne sont pas prévus. Dans cette variante, ces éléments peuvent être remplacés par tout circuit apte à remettre la bascule 431 à zéro après mémorisation d'un franchissement de seuil, par exemple après un délai donné pour mettre fin à la période 510. Dans cette variante, seul l'interrupteur 210-2 est mis à l'état passant au franchissement du seuil VTH par la tension aux bornes de l'interrupteur 210-1. Par rapport à cette variante, le fait de prévoir de mettre également l'interrupteur 210-1 à l'état passant au franchissement du seuil VTH par la tension aux bornes de l'interrupteur 210-2 permet d'améliorer le rendement et la fiabilité du convertisseur.

De préférence, pendant la période 510 d'état passant de l'interrupteur 210-2, la commande SC est appliquée à l'interrupteur 210-1. Lorsque le signal SC est au niveau haut, l'interrupteur bidirectionnel 200 est passant, et la tension V200 aux bornes de l'interrupteur bidirectionnel 200 est, par rapport à la valeur crête de la tension alternative, sensiblement nulle. Lorsque le signal SC est au niveau bas, l'interrupteur bidirectionnel 200 est bloqué, et la tension alternative VAC aux bornes de la cellule de commutation se retrouve aux bornes de l'interrupteur bidirectionnel 200.

Ainsi, chaque créneau de la commande SC provoque un franchissement du seuil VTH par la tension aux bornes de l'interrupteur V210-1 au moment où celui-ci devient bloqué. Un instant t2 de l'un de ces franchissements est représenté.

De préférence, dans chaque demi-alternance positive, la période 510 déclenchée par le franchissement du seuil VTH dure au moins pendant une partie centrale de la demi-alternance. Autrement dit, la période 510 s'étend sur plusieurs cycles de la commande SC (cycle de découpage). Ceci n'est pas limitatif et la période 510 peut être toute période déclenchée par le franchissement du seuil et durant, de préférence, au moins tant que la tension aux bornes de l'interrupteur 210-1 est supérieure au seuil. Cependant, par rapport à des variantes dans lesquelles l'interrupteur 210_2 est remis à l'état bloqué lorsque l'interrupteur 210-1 est passant à chaque cycle de la commande SC, le fait de prévoir que la période 510 s'étende sur plusieurs cycles permet de bénéficier, sans interruption entre les cycles, de la réduction décrite ci-dessus des pertes d'énergie résultant de chutes de tensions dans les diodes.

Dans le cas préféré où le circuit de commande 402 (figure 4) comprend le circuit monostable 471, le franchissement de seuil à l'instant t0 provoque la mise au niveau haut du signal S471 de sortie du circuit monostable 471. Après ce franchissement, et après chacun des franchissements suivants de la demi-alternance positive considérée, le signal S471 reste au niveau haut pendant une durée DLY d'impulsion du circuit monostable 471.

De préférence, la durée DLY est supérieure au temps de cycle de la commande SC et le circuit monostable est redéclenchable, d'où il résulte que le signal S471 reste au niveau haut tant que l'application de la commande SC provoque des franchissements de seuils, c'est-à-dire tant que la tension VAC est supérieure au seuil VTH au moment où l'interrupteur 210-1 passe à l'état bloqué.

A un instant t3, dans la demi-alternance positive considérée, un dernier franchissement de seuil se produit. Le signal S471 passe au niveau bas à un instant t4 située à un délai prédéfini après l'instant t3, constitué par la durée DLY.

Dans un mode de réalisation, le circuit de commande 402 comprend la porte logique ET 462 (figure 4) et une liaison entre la sortie du circuit monostable 471 et la porte logique ET 462. Dans l'exemple représenté, cette liaison est effectuée par l'intermédiaire de la porte logique OU 480, mais cette liaison peut être une connexion directe ou toute liaison adaptée à transmettre un signal. L'interrupteur 210-2 est mis à l'état bloqué à partir de l'instant t4. Selon un avantage, on évite que l'interrupteur bidirectionnel 200 soit mis un court-circuit au début de l'alternance négative suivante, avant l'instant t1. Pour cela, de préférence, la durée DLY est choisie en fonction du seuil VTH, de la valeur crête et de la fréquence de la tension alternative VAC, de telle sorte que l'instant t4 soit situé avant la fin de la demi-alternance positive considérée. Pour cela, à titre d'exemple, la durée DLY est comprise entre 0,1 % et 1 % de la durée d'une alternance (deux demi-alternances successives), par exemple entre 20 µs et 100 µs.

Dans un autre mode de réalisation où le circuit de commande 402 comprend la porte logique ET 461 (figure 4), l'application de la commande SC à l'interrupteur 210-1 s'arrête à l'instant t4 à partir duquel l'interrupteur 210-1 est à l'état bloqué.

Ainsi, dans une combinaison des deux modes de réalisation ci-dessus, l'application de la commande SC à l'interrupteur 210-1 et la mise à l'état passant de l'interrupteur 210-2 se terminent à l'instant t4. A l'instant t3, le dernier franchissement de seuil au cours de l'alternance positive est également le dernier franchissement de seuil au cours de la période 510. A une période de temps 530 située entre les périodes 510 et 520 successives, les deux interrupteurs 210-1 et 210-2 sont à l'état bloqué.

De manière similaire, dans un mode de réalisation où le circuit de commande 402 comprend le circuit monostable 472, la période 520 d'application de la commande SC à l'interrupteur 210-2 et de mise à l'état passant de l'interrupteur 210-1 peut se terminer à un instant t5 situé à un délai DLY après un instant t6 d'un dernier franchissement de seuil au cours de la période 520 par la tension aux bornes de l'interrupteur 210-2. Entre l'instant t5 et l'instant t0 suivant, à une période de temps 540 située entre les périodes 520 et 510 consécutives, les deux interrupteurs 210-1 et 210-2 sont à l'état bloqué.

Dans l'exemple représenté du circuit de commande 402 de la figure 4, la porte logique OU 480 permet d'obtenir à la fois les périodes 530 et les périodes 540. Les périodes 530 et 540 sont intercalées entre les périodes 510 et 520. Les périodes 530 et 540 sont chacune située à cheval sur deux demi-alternances consécutives.

Les modes de réalisation décrits ci-dessus ne sont pas limitatifs, et, selon un mode de réalisation dans lequel les circuits monostables 471 et 472, les portes logiques ET 461 et 462, et la porte logique OU 480 sont omis, les périodes 510 et 520 s'étendent respectivement de l'instant t0 à l'instant t1, et de l'instant t1 à l'instant t0 suivant. Par rapport à ce mode de réalisation, la prévision des périodes 530 et 540 permet d'éviter un risque de mettre temporairement l'interrupteur en court-circuit, dans une demi-alternance positive avant l'instant t0, et/ou dans une demi-alternance négative avant l'instant t1.

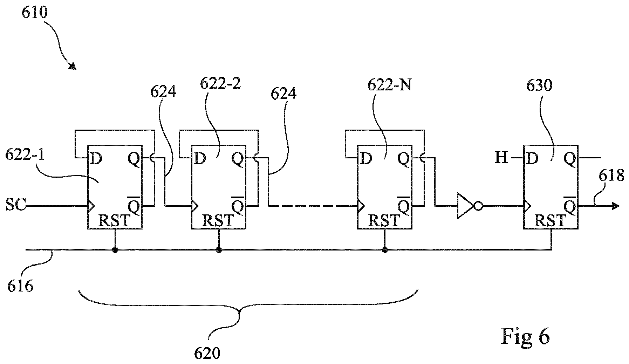

La figure 6 représente, de manière schématique, un exemple d'un mode de réalisation d'un circuit monostable 610 pouvant constituer le circuit monostable 471 et/ou le circuit monostable 472 du circuit de commande 402 de la figure 4.

Le circuit monostable 610 comprend un compteur à bascules 620. Le compteur à bascules 620 est défini par un ensemble de bascules 622-i (622-1, 622-2, ..., 622-N, i étant un indice variant de 1 à un nombre N de bascules 622-i) reliées en chaîne, dans lequel :
- la chaîne est formée par des liaisons 624, de préférence des connexions, entre une sortie de chaque bascule 622-i et une entrée d'horloge de la bascule suivante ;
- une bascule 622-N de fin de la chaîne a une sortie constituant, ou reliée ou connectée à, la sortie du compteur à bascule 620 ;
- une bascule 622-1 de début de la chaîne a une entrée d'horloge constituant, ou reliée ou connectée à, une entrée d'horloge du compteur à bascule 620 ; et
- dans chaque bascule 622-i, une autre sortie est reliée, de préférence connectée, à une entrée de donnée D de la bascule 622-i.

Dans l'exemple représenté, les liaisons 624 entre bascules 622-i sont entre les sorties non inversées Q et les entrées d'horloge, et les sorties inversées Q̅ sont reliées aux entrées D.

A chaque front montant de l'horloge, la bascule 622-1 change de niveau. Les changements de niveau de la bascule 622-1 ont une fréquence moitié de celle reçue sur l'entrée d'horloge du compteur 620. Chaque bascule 622-i change de niveau à une fréquence moitié de la bascule précédente de la chaîne.

De préférence, l'entrée d'horloge reçoit la commande en créneaux SC. En variante, l'entrée d'horloge peut recevoir tout signal en créneaux ou signal d'horloge. Par rapport à cette variante, le fait d'utiliser la commande en créneaux SC comme horloge pour le compteur 620 permet avantageusement d'éviter de prévoir une horloge supplémentaire et, comme ceci est décrit ci-après, d'obtenir que la durée d'impulsion obtenue du circuit monostable 610 soit égale à un nombre prédéfini de cycles de la commande SC.

De préférence, les bascules 622-i du compteur 620 ont une entrée RST asynchrone de mise à zéro de la bascule lorsque l'entrée RST reçoit un niveau haut. Les entrées RST des bascules 622-i sont reliées, de préférence connectées, à une entrée 616 du circuit monostable 610. Comme ceci est mentionné ci-dessus, l'entrée 616 du circuit monostable 610 est reliée à la sortie du comparateur 411 ou 412 (figure 4) concerné.

En fonctionnement, à chaque franchissement de seuil, les bascules 622-i sont remises à zéro. Autrement dit, le compteur est remis à zéro. Ceci est déclenché par un front descendant de la commande SC, qui provoque le blocage de l'interrupteur bidirectionnel 200. Tant que la tension alternative VAC est supérieure au seuil VTH (figure 5), le compteur 620 est remis à zéro à chaque cycle de la commande SC.

A partir du dernier franchissement de seuil de la demi-alternance concernée (instant t3 ou t6 en figure 5), le compteur n'est plus remis à zéro à chaque cycle. Dans l'exemple représenté, le front montant suivant de la commande SC provoque un changement de niveau de toutes les bascules 622-i de la chaîne et la sortie du compteur 620 passe au niveau haut. Ensuite, les changements de niveaux des bascules 622-i se produisent. Au bout de 2^{N-1} cycles de la commande SC, c'est-à-dire à la fin du délai DLY, la sortie du compteur 620 passe au niveau bas. On a ainsi provoqué un front descendant en sortie du compteur 620 à la fin du délai DLY. A titre d'exemple, le nombre N des bascules 622-i du compteur est compris entre trois et huit, par exemple égal à quatre. Le nombre N des bascules constitue un paramètre de réglage du délai DLY et n'est pas limité à cet exemple particulier, le nombre N pouvant être supérieur à huit, par exemple égal à dix.

De préférence, le circuit monostable 610 comprend en outre une bascule 630 de type D recevant un niveau logique haut (H) sur son entrée D de donnée, et recevant l'inverse de la sortie du compteur 620 sur son entrée d'horloge. La sortie inversée Q̅ de la bascule 630 constitue, ou est reliée ou connectée à, la sortie 618 du circuit monostable 610. La bascule 630 a une entrée RST asynchrone de mise à zéro reliée, de préférence connectée, à l'entrée 616 du circuit monostable 610.

En fonctionnement, tant que la tension alternative VAC est supérieure au seuil VTH (figure 5), la bascule 630 est remise à zéro à chaque cycle de la commande SC, et la sortie du circuit monostable 610 est à 1. Le front descendant en sortie du compteur 620 à la fin du délai DLY provoque la mise au niveau bas de la sortie du circuit monostable 610. Si, après la fin de ce délai, le compteur 620 produit d'autres fronts à sa sortie, la sortie du circuit monostable 610 reste au niveau bas. Ainsi, la bascule 630 a pour fonction de maintenir le niveau haut de la sortie du circuit monostable 610 avant l'écoulement du délai DLY et de maintenir le niveau bas de cette sortie après écoulement du délai DLY.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, bien que l'on ait décrit, en relation avec la figure 4, un circuit 402 particulier configuré pour mettre en œuvre les modes de réalisation de procédé décrits en relation avec la figure 5, le circuit 402 peut être constitué par tout circuit configuré pour mettre en œuvre au moins l'un des modes de réalisation du procédé. De tels circuits sont à la portée de la personne du métier à partir du fonctionnement défini par les modes de réalisation du procédé décrits ci-dessus.

Plus particulièrement, pour chacun des signaux décrits ci-dessus, on peut échanger les niveaux logiques haut et bas en adaptant les circuits produisant et recevant le signal, en particulier en adaptant les types des portes logiques, les sorties utilisées des bascules et/ou les sens de front d'horloge des bascules et/ou les niveaux des signaux à appliquer pour les remises à zéro.

Enfin, la mise en œuvre pratique des modes de réalisation et variantes décrits est à la portée de la personne du métier à partir des indications fonctionnelles données ci-dessus.

## Revendications

1. Procédé de commande de premier (210-1) et deuxième (210-2) interrupteurs électriquement en série, lesdits interrupteurs étant des transistors à effet de champ dont des bornes de source sont interconnectées dans lequel :
un ou des franchissements d'un premier seuil de tension (VTH) par une tension aux bornes du premier interrupteur provoquent un état passant du deuxième interrupteur ; et
un ou des franchissements d'un deuxième seuil de tension (VTH) par une tension aux bornes du deuxième interrupteur provoquent un état passant du premier interrupteur.

2. Procédé selon la revendication 1, dans lequel des premières périodes (510) d'application d'une commande en créneaux (SC) au premier interrupteur (210-1) et d'état passant du deuxième interrupteur débutent par lesdits franchissements.

3. Procédé selon la revendication 2, dans lequel chaque créneau de la commande (SC) provoque un autre franchissement du seuil de tension (VTH) par la tension aux bornes du premier interrupteur (210-1), et chaque première période (510) se termine à un délai prédéfini (DLY) après un dernier desdits autres franchissements situés dans la première période.

4. Procédé selon l'une quelconque des revendication 1 à 3, dans lequel lesdits états passants des deuxième et premier transistors court-circuitent leurs diodes intrinsèques respectives.

5. Procédé selon l'une quelconque des revendication 1 à 3, dans lequel chaque transistor est associé à une diode en antiparallèle court-circuitée pendant lesdits états passants.

6. Procédé selon l'une quelconque des revendications 1 à 5, dans lequel des deuxièmes périodes (520) d'application de la commande en créneaux (SC) au deuxième interrupteur (210-2) et d'état passant du premier interrupteur (210-1) débutent par lesdits franchissements du deuxième seuil.

7. Procédé selon la revendication 6, dans lequel chaque créneau de la commande (SC) provoque un autre franchissement du deuxième seuil (VTH) par la tension aux bornes du deuxième interrupteur (210-1), et chaque deuxième période (520) se termine à un délai prédéfini (DLY) après un dernier desdits autres franchissements du deuxième seuil situés dans la deuxième période.

8. Procédé selon la revendication 6 ou 7, comprenant, entre les premières périodes (510) et les deuxièmes périodes (520), des troisièmes périodes (530, 540) de mise à l'état bloqué des deux interrupteurs.

9. Procédé selon l'une quelconque des revendications 1 à 8, dans lequel lesdites tensions aux bornes des premier et deuxième interrupteurs sont référencées par rapport à leur une borne (252) de source commune, et les franchissements sont des passages depuis des valeurs absolues inférieures aux premier et deuxième seuils de tension (VTH) respectifs vers des valeurs absolues supérieures, lesdits premier et deuxième seuil étant de préférence de même valeur.

10. Procédé selon la revendication 9, dans lequel les premier (210-1) et deuxième (210-2) interrupteurs comprennent des transistors (T1, T2) à effet de champ, de préférence de type HEMT GaN.

11. Circuit (402) configuré pour mettre en œuvre un procédé selon l'une quelconque des revendications 1 à 10.

12. Circuit selon la revendication 11, comprenant :
- un premier comparateur (411) recevant ladite tension aux bornes du premier interrupteur et ledit premier seuil de tension (VTH), et un circuit logique (431) adapté à mémoriser ledit un ou plusieurs franchissements et relié à la sortie du comparateur ; et
- un deuxième comparateur (412) recevant ladite tension aux bornes du deuxième interrupteur et ledit deuxième seuil de tension (VTH), et un circuit logique supplémentaire (432) adapté à mémoriser ledit un ou plusieurs franchissements supplémentaire et relié à la sortie du deuxième comparateur.

13. Circuit selon la revendication 12, comprenant :
- un premier circuit monostable (471) ayant une entrée reliée à la sortie dudit comparateur (411) ; et
- de préférence, un deuxième circuit monostable supplémentaire ayant une entrée reliée à la sortie dudit deuxième comparateur (412).

14. Circuit selon la revendication 13 dans sa dépendance à la revendication 2, dans lequel le premier circuit monostable (471) comprend un compteur à bascules (620) configuré pour recevoir la commande en créneaux (SC) sur une entrée d'horloge.

15. Dispositif (400) monolithique comprenant un circuit (402) selon l'une quelconque des revendications 11 à 14, et, de préférence, les premier (210-1) et deuxième (210-2) interrupteurs.

16. Convertisseur à découpage configuré pour recevoir et/ou fournir une tension alternative (VAC), comprenant un ou plusieurs circuits (402) selon l'une quelconque des revendications 11 à 14 ou un dispositif (400) selon la revendication 15.
